Europäisches Patentamt

(19) European Patent Office

Office européen des brevets

(11) Numéro de publication: **0 013 344**

A1

## (12) DEMANDE DE BREVET EUROPEEN

(21) Numéro de dépôt: **79104885.3**

(22) Date de dépôt: **04.12.79**

(51) Int. Cl.³: **H 03 K 19/013**
**H 03 K 19/091, H 03 K 19/20**
**H 01 L 27/04**

(30) Priorité: **22.12.78 US 972383**

(43) Date de publication de la demande:
**23.07.80 Bulletin 80/15**

(84) Etats Contractants Désignés:
**DE FR GB**

(71) Demandeur: **International Business Machines
Corporation**

**Armonk, N.Y. 10504(US)**

(72) Inventeur: **Hellwarth, George, Arlen
1102 SE 10th Terrace
Deerfield Beach, Florida 33441(US)**

(72) Inventeur: **Holloway, John Francis
200 NW 7th Court
Boca Raton, Florida 33432(US)**

(72) Inventeur: **Schulz, Raymond Andrew
1057 NW 6th Drive
Boca Raton, Florida 33432(US)**

(74) Mandataire: **Gallois, Gerard
COMPAGNIE IBM FRANCE Département de Propriété
Industrielle
F-06610 - La Gaude(FR)**

(54) **Circuit logique NI du type non saturé.**

㊳ Le circuit logique NI du type non saturé reçoit les signaux d'entrée aux bornes (12) à (18) des bases des transistors d'entrée (20) à (26). Lorsqu'aucun signal de niveau haut n'est appliqué aux bornes d'entrée aucun des transistors d'entrée n'est passant. La ligne (28) est pratiquement au niveau de la source d'alimentation V. Par suite, le transistor (48) de verrouillage est bloqué et le transistor de sortie (40) est conducteur si bien que la borne de sortie (42) est à un niveau haut. Si une des bornes d'entrée est à un niveau haut, la tension sur la ligne (28) tombe mais est maintenue à un niveau tel par le transistor de verrouillage (48) qu'aucun des transistors d'entrée n'est saturé. Le transistor (40) étant monté en emetteur-suiveur, la borne de sortie (42) est au niveau bas. Les transistors (40) et (48) ne peuvent être à aucun moment saturés. Le circuit a donc une grande vitesse de commutation et peut être réalisé en circuit intégré sur une faible surface.

FIG. 2

Croydon Printing Company Ltd.

EP 0 013 344 A1

I

# CIRCUIT LOGIQUE NI DU TYPE NON SATURE

## Description

### Domaine technique

La présente invention concerne les circuits électroniques numériques et, plus particulièrement, un circuit logique NI du type non saturé.

### Etat de la technique antérieure

De nombreuses familles de portes logiques ont jusqu'à présent été mises au point pour les besoins de circuits logiques employés dans des applications numériques en matière de communications, de calculateurs et de systèmes d'instrumentation. Les familles existantes de portes logiques comprennent la logique diode-transistor (DTL), la logique résistance-transistor (RTL), la logique transistor-transistor (TTL), la logique de commutation de courant du type émetteur-suiveur (CSEF) également dite logique à émetteurs couplés (ECL), la logique statique et dynamique du type métal-oxyde-semiconducteur (MOS), etc. Chaque famille logique présente certaines caractéristiques en ce qui concerne la vitesse de fonctionnement, la consommation de courant, le coût, la complexité et les dimensions, qui rendent une famille donnée plus souhaitable que d'autres en fonction de l'utilisation prévue des éléments logiques.

Une telle famille de circuits logiques est décrite dans le brevet des E.U.A. No. 3 505 535. Ce brevet concerne un commutateur de courant à émetteur-suiveur dans lequel on évite la saturation des transistors d'entrée au moyen d'un réseau à impédance variable utilisé dans

2

le circuit de collecteur. Les signaux logiques d'entrée
appliqués à la porte par l'intermédiaire des transistors
d'entrée sont comparés avec une tension de référence de
manière à obtenir des sorties complémentaires aux
bornes d'émetteur de transistors fonctionnant en émetteurs-suiveurs.

Dans les domaines de la technique qui font appel à
l'emploi de circuits numériques, notamment dans les
calculateurs, il serait souhaitable de pouvoir disposer
d'une famille de circuits logiques perfectionnés présentant des caractéristiques supérieures à celles des
circuits actuels. Une augmentation de la vitesse de
fonctionnement, une diminution de la consommation de
courant, une réduction des impératifs afférents aux
dispositifs auxiliaires tels que les générateurs de
tension de référence, et une diminution de l'espace
requis pour réaliser un circuit logique sont souhaitable de manière à pouvoir fabriquer des circuits
présentant une densité nettement plus élevée et un prix
de revient inférieur, en utilisant la technique dite
d'intégration à grande échelle (LSI).

Exposé de l'invention

La présente invention permet de réaliser un circuit
logique NI dans lequel on évite la saturation de chacun
des transistors bipolaires.

Le circuit logique NI du type non saturé de la présente
invention comporte une borne de sortie et plusieurs
bornes d'entrée ainsi qu'un premier et qu'un second
conducteurs d'alimentation qui permettent de recevoir
une tension d'une source appropriée. Plusieurs transistors d'entrée comportant chacun un émetteur, une base
et un collecteur sont disposés de telle sorte que chaque base soit connectée à une borne d'entrée logique distincte. Une résistance est connectée à une première borne de même que les émetteurs des transistors d'entrée, et à sa seconde borne au second conducteur d'alimentation. Le circuit comporte une diode dont la cathode est connectée aux collecteurs des transistors d'entrée et dont l'anode est connectée au premier conducteur d'alimentation. Cette diode est polarisée en direct lorsque l'un quelconque des transistors d'entrée devient passant. Les collecteurs des transistors d'entrée sont connectés en parallèle à une première borne d'une seconde résistance dont la seconde borne est connectée au premier conducteur d'alimentation. Un transistor de sortie est prévu, dont le collecteur est connecté au premier conducteur d'alimentation, dont la base est connectée aux collecteurs des transistors d'entrée et dont l'émetteur fait fonction de borne de sortie du circuit logique. Une troisième résistance est connectée entre l'émetteur du transistor de sortie et le second conducteur d'alimentation, de manière à permettre au transistor de sortie de fonctionner en émetteur-suiveur.

Selon une autre caractéristique de la présente invention, le circuit logique NI du type non saturé comporte une borne de sortie et plusieurs bornes d'entrée ainsi qu'un premier et un second conducteurs d'alimentation permettant de recevoir une tension d'une source appropriée. Le circuit comporte plusieurs transistors d'entrée, la base de chacun desquels est connectée à l'une des bornes d'entrée logique. Les émetteurs des transistors d'entrée sont tous connectés en commun à une première résistance dont la seconde borne est connectée au second conducteur d'alimentation. Le circuit comprend en outre un transistor de limitation ou de verrouillage dont la base et le collecteur sont connectés l'un à l'autre ainsi qu'au premier conducteur d'alimentation, l'émetteur étant connecté aux collecteurs en commun des transitors d'entrée. Une seconde résistance est connectée entre le premier conducteur d'alimentation et les collecteurs en commun des transistors d'entrée. Le circuit comprend un transistor de sortie dont le collecteur est connecté au premier conducteur d'alimentation, dont la base est connectée aux collecteurs des transistors d'entrée et dont l'émetteur est connecté à la borne de sortie logique. Une troisième résistance est connectée entre l'émetteur du transistor de sortie et le second conducteur d'alimentation de manière à permettre au transitor de sortie de fonctionner en émetteur-suiveur.

## Brève description des figures

D'autres objets, caractéristiques et avantages de la présente invention ressortiront mieux de l'exposé qui suit, fait en référence aux dessins annexés à ce texte, qui représentent un mode de réalisation préféré de celle-ci.

La Figure 1 représente schématiquement le circuit logique NI de la présente invention.

La Figure 2 représente schématiquement une autre réalisation du circuit logique NI de la présente invention.

La Figure 3 représente schématiquement une réalisation du circuit logique NI de la présente invention sous la forme d'un circuit intégré.

## Description de l'invention

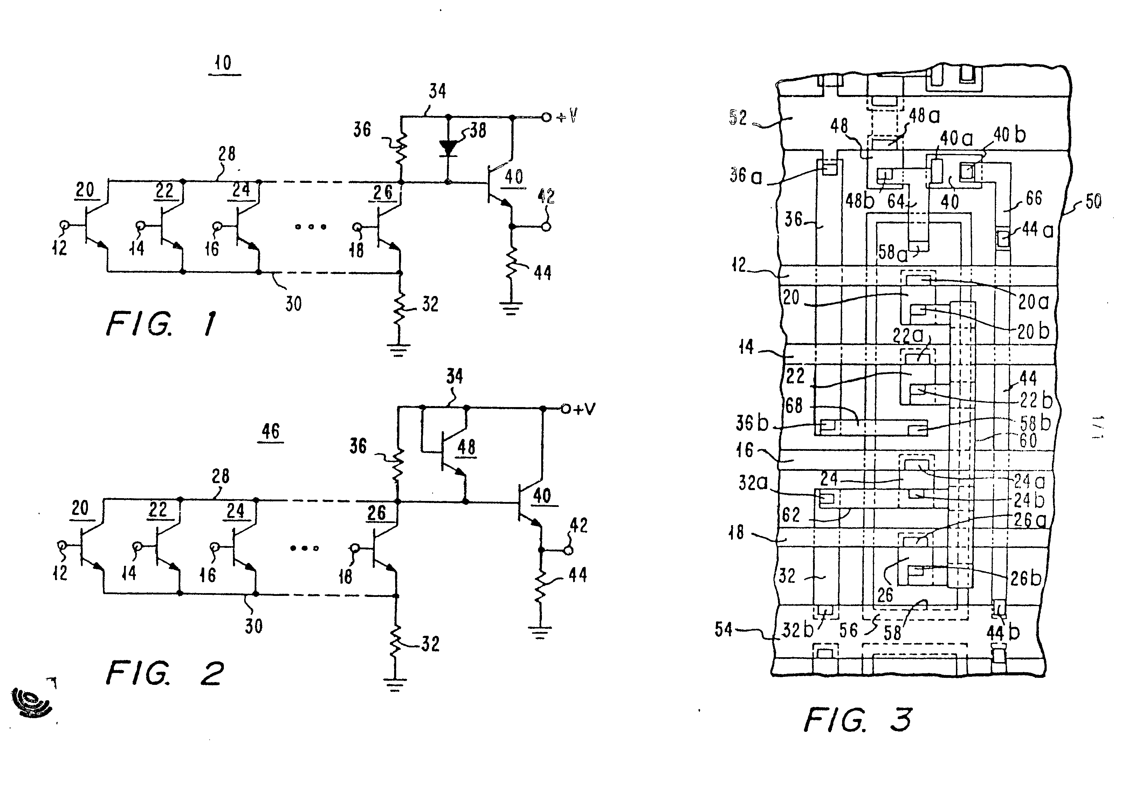

On a représenté sur la Figure 1 une première réalisation de la présente invention dans laquelle le circuit logique NI, référencé 10, comporte plusieurs bornes d'entrée, 12, 14, 16 et 18 qui sont respectivement connectées à la base de transistors d'entrée 20, 22, 24 et 26. Le collecteur de chacun des transistors d'entrée est relié à une ligne commune 28, cependant que l'émetteur de chacun de ces transistors est connecté à une ligne 30. Une résistance d'émetteur 32 est commune aux transistors d'entrée et est connectée entre la ligne 30 et la masse. Le circuit logique 10 peut comporter un nombre quelconque de bornes d'entrée et il suffit pour cela de prévoir un transistor d'entrée par borne, ce transistor d'entrée étant connecté entre les lignes 28 et 30 de la façon indiqué sur la Figure dans le cas des transistors d'entrée 20, 22, 24 et 26.

Le circuit logique 10 est alimenté, par l'intermédiaire d'une ligne commune 34, connectée à une source de tension (non représentée) qui fournit une tension positive V par rapport à la masse. Une résistance 36 est connectée entre les lignes 34 et 28 de manière à consituer un chemin de conduction entre les collecteurs des transistors d'entrée et la source de tension. Le circuit comporte une diode 38 dont l'anode est connectée à la ligne commune 34 et dont la cathode est connectée à la ligne commune 28. Un transistor de sortie 40 engendre le signal de sortie du circuit logique sur la borne 42 associée à son émetteur. Le collecteur du transistor de sortie 40 est connecté à la ligne commune 34 afin de recevoir la tension d'alimentation. La ligne commune 28 est connectée à la base du transistor de sortie 40 et relie celle-ci au collecteur de chacun des transistors d'entrée 20, 22, 24 et 26, et connecte la résistance 36 et l'anode de la diode 38. L'émetteur du transistor le sortie 40 est connecté à une résistance 44 qui est elle-même reliée à la masse.

Le circuit 10 de la Figure 1 fonctionne à la façon d'une porte logique NI dans laquelle un signal "vrai" est obtenu à la borne de sortie 42 lorsqu'un signal "faux" est présent à chacune des bornes d'entrée 12, 14, 16 et 18. Un signal "faux" est obtenu à la borne de sortie 42 lorsqu'un signal "vrai" est présent à l'une quelconque des bornes d'entrée 12, 14, 16 et 18.

La présente invention est décrite ci-après par référence à une logique positive dans laquelle un signal "vrai" est représenté par une tension haute et un signal "faux" par une tension basse. On considérera tout d'abord l'état du circuit 10 lorsqu'une tension basse est appliquée à chacune de ces bornes d'entrée. Dans la présente invention, une tension basse est définie comme une tension inférieure à la tension de polarisation directe base-émetteur des transistors d'entrée. Compte tenu de cette limitation, la tension appliquée à la base de chacun des transistors d'entrée ne suffit pas à rendre ceux-ci passants. Chacun des transistors d'entrée est donc bloqué et il existe un chemin présentant une impédance élevée entre les lignes 28 et 30. Le seul chemin par lequel le courant peut circuler entre la ligne 28 et la masse est celui qui passe par la jonction base-émetteur du transistor de sortie 40 et par la résistance 44. La jonction base-émetteur du transistor 40 ne laisse passer qu'une très faible quantité de courant, généralement de l'ordre de quelques micro-ampères. De ce fait, la chute de tension aux bornes de la résistance 36 est négligeable et la tension qui apparaît sur la ligne 28 est essentiellement la même que celle qui apparaît sur la ligne d'alimentation 34.

Etant donné que des niveaux de tension virtuellement identiques sont présents sur l'anode et sur la cathode de la diode 38, cette dernière n'est pas polarisée dans le sens direct et présente effectivement une impédance très élevée. Un courant pratiquement nul traversera donc la diode 38.

La présence de la totalité de la tension d'alimentation à la base du transistor de sortie 40 par rapport à l'émetteur connecté à la masse par l'intermédiaire de la résistance 44, crée une polarisation directe aux bornes de la jonction base-émetteur, ce qui a pour effet de rendre le transitor 40 passant dans une certaine mesure. Selon le type particulier de transistor employé, une chute de tension substantielle se produit à travers la jonction base-émetteur, et le niveau de tension présent à la borne de sortie 42 correspond à la tension d'alimentation moins la tension présente aux bornes de la jonction base-émetteur du transistor 40, soit $V-V_{be}$. Cette tension est définie dans le cas du présent circuit comme étant le niveau logique haut ou le niveau logique "1" (signal "vrai").

On considérera à présent le cas dans lequel une ou plusieurs des bornes d'entrée 12, 14, 16 et 18 du circuit 10 sont à ce niveau logique "1" ou niveau haut comme défini précédemment. Ce niveau est supérieur à la tension de la jonction base-émetteur du transistor, si bien que lorsqu'il est appliqué à la base du transistor d'entrée il provoque une polarisation directe qui rend celui-ci passant. Lorsque l'un quelconque des transistors d'entrée est ainsi rendu passant, un chemin de faible impédance est formé entre les lignes 28 et 30. Un chemin en série est donc formé entre la ligne commune 34 et la masse en passant par la résistance 36, le transistor de faible impédance et la résistance 32. Ce chemin permet le passage du courant et il se produit une chute de tension aux bornes de la résistance 36, ce qui a pour effet de diminuer le niveau de tension présent sur la ligne 28. Ce niveau diminue jusqu'à ce que la différence de tension entre les lignes 28 et 34 soit suffisante pour provoquer la polarisation directe de la diode 38. Lorsque celle-ci devient passante, elle présente un chemin de faible impédance entre les lignes 28 et 34 qui s'oppose à toute nouvelle diminution de la tension sur la ligne 28. La diode 38 verrouille en fait la tension présente sur la ligne 28 à un niveau qui correspond à la tension d'alimentation V moins la tension de polarisation directe aux bornes de la diode 38.

Ce verrouillage de la tension présente sur la ligne 28 à un niveau légèrement inférieur à celui de la tension V fournie par la source d'alimentation a pour effet d'interdire la saturation de chacun des transistors d'entrée. La saturation de ces derniers ne peut avoir lieu que lorsque la tension de base du transistor dépasse sa tension de collecteur de la valeur nécessaire pour provoquer la polarisation directe de la jonction base-collecteur du transistor d'entrée. La tension la plus faible qui peut être présente sur la ligne 28 est approximativement la même que la tension la plus élevée appliquée à la base de l'un quelconque des transistors d'entrée. Ainsi, le verrouillage assuré par la diode 38 interdit la saturation des transistors d'entrée.

La tension présente sur la ligne 28 varie donc entre deux niveaux qui diffèrent d'une valeur correspondant à la tension de polarisation directe de la diode 38. Lorsque l'un des transistors d'entrée a été rendu passant et que la tension présente sur la ligne 28 est tombée à son niveau inférieur, la tension de polarisation présente à la base du transistor de sortie 40 est également moindre. Etant donné que ce dernier transistor est connecté en émetteur-suiveur, le niveau de tension présent à la borne de sortie 42 est décalé de la valeur de la chute de tension entre la base et l'émetteur du transistor 40. L'excursion de tension au niveau de la borne de sortie 42 correspond donc approximativement à la tension de polarisation directe de la diode 38 lorsque celle-ci est passante.

On a représenté sur la Figure 2 une variante de la présente invention. Le circuit logique 46 diffère de celui de la Figure 1 en ce que la diode 38 a été remplacée par un transistor 48. La base et le collecteur du transistor 48 sont connectés à la ligne commune d'alimentation 34. L'émetteur du transistor 48 est connecté à la ligne 28 qui est également connectée à la base du transistor 40.

Le transistor 48 fonctionne d'une façon analogue à la diode 38 de la Figure 1. Lorsque toutes les bornes d'entrée 12, 14, 16 et 18 sont au niveau bas, l'émetteur du transistor 48 est essentiellement au même potentiel que sa base et son collecteur. En pareil cas, le transistor 48 n'est pas dans le sens en direct et présente une impédance très élevée entre les lignes 28 et 34. Cela étant, le transistor 40 est polarisé dans le sens direct et la tension présente à la borne 42 est égale à la tension d'alimentation moins la tension présente aux bornes de la jonction base-émetteur du transitor 40.

Lorsque l'une quelconque des bornes d'entrée 12, 14, 16 ou 18 est au niveau haut de manière à polariser dans le sens direct le transistor d'entrée correspondant, l'impédance présente entre les lignes 28 et 30 est nettement réduite, ce qui permet de diminuer la tension présente sur la ligne 28. Lorsque cette dernière tension est suffisamment basse pour provoquer une polarisation dans le sens direct de la jonction base-émetteur du transistor 48, celui-ci présente un chemin d'impédance réduite entre les lignes 28 et 34. Cela a pour effet de verrouiller la tension présente sur la ligne 28 à un niveau qui est égal à la tension d'alimentation moins la tension de la jonction base-émetteur du transistor 48. Lorsque la tension de la ligne 28 a été ramenée à ce niveau bas, la polarisation appliquée à la base du transistor 40 diminue de manière similaire. Etant donné que le transistor 40 fonctionne en émetteur-suiveur, la tension de l'émetteur diminue d'une valeur égale à la variation de tension sur la ligne 28. La tension présente à la borne de sortie 42 est réduite de la valeur de la tension de la jonction base-émetteur du transistor 48. Ainsi, les niveaux logiques présents à la borne de sortie 42 correspondront à la valeur de la tension d'alimentation diminuée de la tension de la jonction base-émetteur du transistor 40 pour un niveau logique "1", et à la tension d'alimentation diminuée de la somme de la tension de la jonction base-émetteur du transistor 40 et de la jonction base-émetteur du transistor 48 dans le cas d'un niveau logique "0". L'excursion de tension présente au niveau de la borne de sortie 42 est la tension de la jonction base-émetteur du transistor 48.

Une tension d'alimentation qui varie en fonction de la température est importante si le circuit doit être employé dans une vaste plage de températures. La valeur de la tension d'alimentation la plus convenable est égale au double de la chute de tension de la diode augmentée d'une constante d'environ 0,5 volt. Cela donne le meilleur coefficient de température d'alimentation du point de vue de l'obtention d'une polarisation adéquate du circuit.

Lorsqu'elle est réalisée dans un circuit logique, la porte logique 46 de la Figure 2 est connectée à une source d'alimentation qui produit 2,1 volts à température ambiante. Les transistors 40 et 48 sont des transistors bipolaires classiques du type réalisé par intégration à grande échelle. A température ambiante, ces transistors présentent une tension typique de polarisation de la jonction base-émetteur dans le sens direct de 0,8 volt à 1 milliampère de courant émetteur. Les niveaux logiques ainsi obtenus à la borne de sortie 42 sont de 1,3 volt pour une "1" logique et de 0,5 volt pour un "0" logique dans le cas d'une logique positive.

La tension présente à température ambiante sur la ligne 28 varie entre la valeur de 2,1 volts fournie par l'alimentation et la valeur de 1,3 volt représentant la tension d'alimentation moins la tension de polarisation dans le sens direct de la jonction base-émetteur du transistor 48. L'excursion de tension sur la ligne 28 est donc de 0,8 volt.

Les niveaux logiques appliqués aux transistors d'entrée à température ambiante sont de même définis comme étant égaux à 1,3 volt dans le cas d'un "1" logique et à 0,5 volt dans le cas d'un "0" logique. La tension présente à la base de n'importe lequel des transistors d'entrée ne dépassera donc jamais 1,3 volt cependant que la tension présente au niveau du collecteur ne sera jamais inférieure à 1,3 volt. Les transistors d'entrée ne peuvent donc jamais être portés à saturation et ne subiront aucun des retards qu'entraîne le fonctionnement dans la région de saturation. De même le transistor 48 ne peut pas être saturé étant donné que sa base et son collecteur sont interconnectés de manière à s'opposer à toute polarisation aux bornes de la jonction base-collecteur. Enfin, le transistor de sortie 40 ne peut pas être saturé parce que son collecteur est maintenu au niveau de 2,1 volts fourni par l'alimentation cependant que la tension de sa base varie entre 2,1 volts et 1,3 volt. Il ne se produit donc jamais de polarisation directe d'une jonction base-collecteur qui se traduirait par la saturation d'un transistor. Il ressort de ce qui précède qu'aucun des transistors des circuits logiques 10 et 46 ne peut être saturé.

Le circuit logique de la présente invention peut évidemment être réalisé au moyen de transistors PNP au lieu des transistors NPN représentés sur les Figures 1 et 2 si la polarité de l'alimentation est inversée et si l'on utilise une logique négative.

La Figure 3 représente la réalisation préférée, sous la forme d'un circuit intégré, de la présente invention illustrée sur la Figure 2. La Figure 3 permet également de constater le gain de place que rend possible la présente invention, par comparaison avec le circuit CSEF décrit dans le brevet précité des E.U.A. No. 3 505 535.

Le circuit logique est formé sur un substrat semiconducteur 50 qui comprend un rail métallique 52 faisant fonction de borne Vcc aux fins de l'application de la tension d'alimentation au circuit. Un second rail métallique 54 fait fonction de chemin de masse. Des chemins métalliques sont respectivement prévus pour les bornes d'entrée 12, 14, 16 et 18.

Les transistors d'entrées 20, 22, 24, 26 sont situés dans une poche d'isolement 56 qui les isole électriquement des composants voisins. Une diffusion de collecteurs commune 58 est prévue sur le substrat 50 pour chacun des transistors 20, 22, 24, 26. Des bornes de

13

base 20a, 22a, 24a, 26a sont respectivement connectées aux bornes métalliques d'entrée 12, 14, 16, 18. Des bornes d'émetteur 20b, 22b, 24b, 26b pour les transistors d'entrée sont connectées à une bande 60 d'une seconde couche métallique. Une borne 32a d'une résistance 32 est connectée à un chemin métallique 62 qui est lui-même relié au chemin commun 60 qui interconnecte les émetteurs des transistors d'entrée. Les collecteurs de chacun de ces derniers sont interconnectés par l'intermédiaire de la diffusion de collecteurs commune 58, laquelle est connectée à un chemin métallique 64 par l'intermédiaire d'une borne 58a.

La base 48a et l'émetteur 48b du transistor 48 sont respectivement connectés au rail métallique 52 et au chemin métallique 64. Le collecteur de ce transistor est connecté par l'intermédiaire d'une diffusion de grandes dimensions, telle que la totalité du substrat 50, au rail métallique 52.

La base 40a et l'émetteur 40b du transistor 40 sont respectivement connectés aux chemins métalliques 64 et 66. Ce dernier est lui-même connecté à une borne 44a de la résistance 44. Le collecteur du transitor 40 est connecté de même par l'intermédiaire d'un chemin enterré au rail métallique 52 de manière à connecter ce transistor à la source de tension d'alimentation.

Les bornes 36a et 36b de la résistance 36 sont respectivement connectées au rail métallique 52 et, par l'intermédiaire d'un chemin métallique 68, à la borne 58b de la diffusion de collecteurs 58. Les bornes 32a et 32b de la résistance 32 sont respectivement connectées au chemin métallique 62 et au rail de masse 54. La résistance 44, qui est connectée par l'intermédiaire de la borne 44a au chemin métallique 66, est également connectée par l'intermédiaire de la borne 44b au rail de masse 54. Les résistances 32, 36 et 44 se trouvent au-dessous des bandes métalliques afférentes aux bornes d'entrée 12, 14, 16 et 18 et sont isolées de ces bandes métalliques par des couches isolantes appropriées en oxyde.

Le circuit représenté sur la Figure 3 montre le petit nombre de composants qui permet son incorporation dans la faible superficie que nécessite la réalisation du circuit sur le substrat 50. Une circuit logique classique, tel que le circuit du type CSEF décrit dans le brevet précité des E.U.A. No. 3 505 535, exige une superficie deux fois environ plus importante pour une porte équivalente. Sur la Figure 3, une seule poche d'isolement est nécessaire pour assurer une isolation électrique entre la diffusion de collecteurs 58 et les éléments voisins. Aucun autre composant du circuit ne nécessite de région d'isolement analogue. Cela permet de réduire d'avantage encore la superficie requise. La porte ainsi réalisée peut aisément être reproduite sur le substrat 50 en utilisant de façon efficace la place disponible. L'agencement représenté sur la Figure 3 est l'équivalent direct du circuit représenté sur la Figure 2. C'est également l'équivalent virtuel du circuit de la Figure 1 en raison de sa réalisation sous la forme d'un circuit intégré dans lequel la diode 38 est construite sous forme d'un transistor dont la base et le collecteur sont reliés à un point commun.

Depuis l'invention des circuits logiques numériques, on a cherché à obtenir pour chaque famille des circuits présentant des caractéristiques supérieures à celles des circuits logiques existant alors. Pour une logique de commutation, l'une des caractéristiques les plus importantes est la vitesse de transition. Il s'agit là

de la caractéristique principale qui limite la vitesse de fonctionnement d'un dispositif utilisant des circuits logiques. Le facteur le plus important qui limite la vitesse de commutation est la saturation du transistor de commutation. La saturation se produit lorsque les jonctions base-émetteur et base-collecteur sont toutes deux polarisées dans le sens direct et qu'un nombre excessif de porteurs existe dans la région de base. Lorsque la polarisation de base d'un transistor saturé est commutée, un intervalle de temps substantiel est nécessaire pour retirer les porteurs de cette région de base. De nombreuses familles de circuits logiques font appel à un fonctionnement des transistors dans le mode saturé et présentent donc une limitation en ce qui concerne la vitesse de commutation. Afin de réduire le temps d'emmagasinage, on a cherché à développer des circuits logiques dans lesquels les transistors ne sont pas saturés, de manière à limiter le nombre de porteurs qui doivent être retirés de la région de base pendant la durée de la transition.

Le circuit décrit dans le brevet précité des E.U.A. No. 3 505 535 fonctionne de telle sorte que l'amplitude du courant appliqué à la porte reste constante indépendamment de l'état du circuit logique. Ce résultat est obtenu en commutant le courant d'une sortie à une autre sortie. En principe, un circuit logique de commutation de courant possède deux sorties dont l'une est l'inverse de l'autre. Afin que le courant puisse être fourni de façon alternée à une sortie ou à l'autre, il est nécessaire de pouvoir disposer d'une tension de référence qui, utilisée en conjonction avec les transistors d'entrée, permet de sélectionner le circuit de sortie dans lequel le courant constant circulera.

La logique à commutation de courant, bien qu'elle per-

16

mette d'obtenir une augmentation appréciable de la vitesse de commutation par rapport à celle offerte par les dispositifs de l'art antérieur, et assure la circulation d'un courant relativement constant, présente un certain nombre d'inconvénients. Tout d'abord, deux sorties sont disponibles et utilisées en commun, ce qui a pour effet d'augmenter le nombre de circuits et de composants requis pour chaque porte logique, et par conséquent d'augmenter la surface requise et de diminuer la densité des portes qui sont susceptibles d'être réalisées au moyen de la technique d'intégration à grande échelle. Deuxièmement, la tension de référence requise nécessite l'emploi d'une seconde source de puissance et la disponibilité d'une région suffisante aux fins du câblage. Troisièmement, le circuit CSEF en question consomme une puissance substantiellement plus importante pour une vitesse donnée que le circuit logique de la présente invention.

Le circuit logique NI du type non saturé qui est ici décrit et qui est appelé $N^2L$, est en avance sur les circuits logiques actuels. Ainsi qu'on peut le constater en le comparant, par exemple, aux circuits logiques décrit dans le brevet précité des E.U.A. No. 3 505 535, le circuit de la présente invention représenté sur les Figures 1 à 3 présente des différences structurelles distinctes qui lui confèrent d'importants avantages fonctionnels. En effet, le circuit de la présente invention fonctionne sans avoir à utiliser de source de tension de référence, et est donc moins complexe et moins cher, compte tenu en particulier du fait que le transistor de référence associé à ladite source de tension n'est pas requis. Par ailleurs, le circuit de l'invention n'utilise pas de sorties complémentaires. En conséquence, le nombre de composants d'une porte donnée est sensiblement plus faible. Cela a pour effet de diminuer le coût de chaque circuit et de permettre d'augmenter la densité des circuits qui peuvent être réalisés dans une région donnée. D'autre part, le câblage est facilité en raison du fait que les lignes de distribution de la tension de référence sont inutiles.

Le circuit logique des Figures 1 à 3 utilise une tension d'alimentation d'environ 2,1 volts au lieu de la tension de 4 volts que nécessitent les circuits logiques de commutation de courant actuels. On réalise donc une économie appréciable de puissance, ce qui constitue un facteur particulièrement important dans le cas de circuits à densité élevée. Par ailleurs, le réseau de verrouillage de la présente invention, constitué par la diode 38 et la résistance 36, d'une part, et le transistor 48 et la résistance 36, d'autre part, limite l'excursion de tension au niveau des collecteurs des transistors d'entrée à 0,8 volt environ, ce qui reduit considérablement la précision requise lors de la fabrication des circuits logiques à l'aide de la technique d'intégration à grande échelle et, par conséquent, diminue le coût de chaque circuit en augmentant le rendement.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

REVENDICATIONS

1.- Circuit logique NI du type non saturé comportant une borne de sortie et plusieurs bornes d'entrée, caractérisé en ce qu'il comprend:

a) un premier et un second conducteurs d'alimentation de tension entre lesquels est appliquée une tension fournie par une source de tension,

b) plusieurs transistors d'entrée comportant chacun un émetteur, une base et un collecteur, la base de chacun desdits transistors étant connectée à une borne d'entrée différente,

c) une première résistance montée entre les émetteurs desdits transistors d'entrée et le second desdits conducteurs d'alimentation,

d) un circuit de verrouillage connecté entre le premier desdits conducteurs d'alimentation et les collecteurs desdits transistors d'entrée,

e) une seconde résistance montée entre les collecteurs desdits transistors d'entrée et le premier desdits conducteurs d'alimentation,

f) un transistor de sortie dont le collecteur, la base et l'émetteur sont respectivement connectés au premier desdits conducteurs d'alimentation, au collecteur desdits transistors d'entrée et à ladite borne de sortie, et

g) une troisième résistance montée entre l'émetteur dudit transistor de sortie et le second desdits conducteurs d'alimentation de manière à permettre

audit transistor de sortie de fonctionner en émetteur-suiveur.

2.- Circuit logique NI du type non saturé selon la revendication 1, caractérisé en ce que

le circuit de verrouillage est constitué par une diode connectée de façon à être polarisée dans le sens direct lorsque l'un quelconque desdits transistors d'entrée est polarisé dans le sens direct.

3.- Circuit logique NI du type non saturé selon la revendication 1, caractérisé en ce que

le circuit de verrouillage est consitué par un transistor ayant un émetteur, une base et un collecteur,la base et le collecteur étant connectés au premier desdits conducteurs d'alimentation et l'émetteur étant connecté aux collecteurs desdits transistors d'entrée.

4.- Circuit logique NI du type non saturé comportant une borne de sortie et plusieurs bornes d'entrée, ledit circuit étant fabriqué sur un substrat semiconducteur et recevant une tension d'alimentation entre un premier et un second conducteurs métalliques, caractérisé en ce qu'il comprend:

a) plusieurs transistors d'entrée réalisés sur ledit substrat de telle sorte qu'ils possèdent une région de collecteur commune entourée d'une poche d'isolation, la base de chacun desdits transistors d'entrée étant connectée par l'intermédiaire d'un chemin métallique à une borne d'entrée distincte,

b) un transistor de verrouillage réalisé sur ledit

001334

substrat de telle sorte que son collecteur soit formé dans ledit substrat et connecté audit premier conducteur métallique, sa base étant connectée audit premier conducteur métallique et son émetteur étant connecté par l'intermédiaire d'un chemin métallique à ladite région de collecteur commune,

c) un transistor de sortie réalisé sur ledit substrat de telle sorte que son collecteur soit formé dans ledit substrat et connecté audit premier conducteur métallique, que sa base soit connectée par l'intermédiaire d'un chemin métallique à ladite région de collecteur commune, et que son émetteur soit connecté à ladite borne de sortie, ledit transistor de sortie possédant une configuration telle qu'il puisse fonctionner en émetteur-suiveur,

d) une première résistance réalisée sur ledit substrat et dont la première borne est connectée audit second conducteur métallique, la seconde borne de ladite première résistance étant connectée par l'intermédiaire d'un chemin métallique aux émetteurs desdits transitors d'entrée,

e) une seconde résistance réalisée sur ledit substrat et dont la première borne est connectée audit premier conducteur métallique, la seconde borne de ladite seconde résistance étant connectée par l'intermédiaire d'un chemin métallique à ladite région de collecteur commune, et

f) une troisième résistance réalisée sur ledit substrat et dont la première borne est connectée audit second conducteur métallique, la seconde borne de ladite troisième résistance étant connectée par l'intermédiaire d'un chemin métallique
à l'émetteur dudit transistor de sortie.

FIG. 1

FIG. 2

FIG. 3

Office européen
des brevets

**RAPPORT DE RECHERCHE EUROPEENNE**

| | DOCUMENTS CONSIDERES COMME PERTINENTS | | CLASSEMENT DE LA DEMANDE (Int. Cl.3) |
|---|---|---|---|
| Catégorie | Citation du document avec indication, en cas de besoin, des parties pertinentes | Revendica-tion concernée | |
| X | DE - B2 - 2 419 543 (SIEMENS AG) <br> * revendications 1 et 2; colonne 2, <br> ligne 49 à colonne 3, ligne 44; <br> fig. 1; <br> colonne 2, lignes 3 à 11 * <br> -- | 1-3 <br><br><br><br> 4 | H 03 K 19/013 <br> H 03 K 19/091 <br> H 03 K 19/20 <br> H 01 L 27/04 |
| X | DE - A1 - 2 634 093 (LICENTIA PATENT-VERWALTUNGS-GMBH) <br> * revendication 1; pages 4 et 5; <br> fig. 2 * <br> -- | 1-3 | |
| | DE - B - 1 512 163 (COMMISSARIAT A L'ENERGIE ATOMIQUE) <br> * revendication 1; fig. 3 * <br> -- | 1,2 | **DOMAINES TECHNIQUES RECHERCHES (Int. Cl.3)** <br><br> H 01 L 27/04 <br> H 03 K 19/013 <br> H 03 K 19/091 <br> H 03 K 19/20 |
| | US - A - 3 795 822 (Z.E. SKOKAN) <br> * colonne 1, lignes 25 à 29 et 59 <br> à 62; colonne 2, lignes 11 à 15; <br> fig. 1 * <br> -- | 1-3 | |
| | US - A - 3 518 449 (D.H. CHUNG) <br> * colonne 3, lignes 36 à 47; fig. 1; <br> fig. 4 * <br> -- | 1 <br><br> 4 | **CATEGORIE DES DOCUMENTS CITES** <br> X: particulièrement pertinent <br> A: arrière-plan technologique <br> O: divulgation non-écrite <br> P: document intercalaire <br> T: théorie ou principe à la base <br> de l'invention |
| A | DE - A - 1 926 057 (NIPPON TELEGRAPH & TELEPHONE PUBLIC CORP.) <br> * fig. 6 * <br> -- ./.. | 1 | E: demande faisant interférence <br> D: document cité dans <br> la demande <br> L: document cité pour d'autres <br> raisons |

&: membre de la même famille, document correspondant

| X | Le present rapport de recherche a été établi pour toutes les revendications |
|---|---|

| Lieu de la recherche <br> Berlin | Date d'achèvement de la recherche <br> 27-03-1980 | Examinateur <br> ARENDT |
|---|---|---|

OEB Form 1503.1  06.78

# Office européen des brevets
# RAPPORT DE RECHERCHE EUROPEENNE

## DOCUMENTS CONSIDERES COMME PERTINENTS

## CLASSEMENT DE LA DEMANDE (Int. Cl.3)

| Catégorie | Citation du document avec indication, en cas de besoin, des parties pertinentes | Revendica-tion concernée |
|---|---|---|
| A | DER FERNMELDE-INGENIEUR, vol.27, no. 7, juillet 1973 Bad Windsheim * pages 21 à 23 * -- | 1 |
| A | US - A - 3 803 426 (P.Y. CONRUYT et al.) * fig. 1 et 2 * -- | 1 |
| A,D | US - A - 3 505 535 (J.R. CAVALIERE) * fig. 1 * ---- | 1 |

## DOMAINES TECHNIQUES RECHERCHES (Int. Cl.3)